Europäisches Patentamt

European Patent Office

Office européen des brevets

(19)

(11) Numéro de publication: **0 016 687**
**A2**

(12) **DEMANDE DE BREVET EUROPEEN**

(21) Numéro de dépôt: **80400322.6**

(22) Date de dépôt: **12.03.80**

(51) Int. Cl.³: **H 03 F 3/217**
**H 05 B 41/29, A 63 J 17/00**

(30) Priorité: **26.03.79 FR 7907499**

(43) Date de publication de la demande:
**01.10.80 Bulletin 80/20**

(84) Etats Contractants Désignés:
**BE CH DE GB IT NL**

(71) Demandeur: **Kneider, François**
**206 Boulevard Aristide Briand**
**F-93100 Montreuil(FR)**

(72) Inventeur: **Kneider, François**
**206 Boulevard Aristide Briand**
**F-93100 Montreuil(FR)**

(74) Mandataire: **Bressand, Georges et al,**
**c/o CABINET LAVOIX 2 Place d'Estienne d'Orves**
**F-75441 Paris Cedex 09(FR)**

(54) **Amplificateur à gain variable et dispositif d'animation d'enseigne lumineuse en comportant application.**

(57) Dispositif d'animation d'enseigne lumineuse constitué par un tube à décharge à gaz rare pourvu d'une électrode à chacune de ses extrémités, ce dispositif comportant un générateur de signaux de fréquence comprise entre 5 et 100 KHz pour alimenter ledit tube, caractérisé en ce qu'il comporte en outre un amplificateur à gain variable (2) connecté à l'entrée dudit générateur (4) et un circuit (1) de commande dudit amplificateur à gain variable (2) en fonction de la tension souhaitée à la sortie de celui-ci.

EP 0 016 687 A2

./...

FIG.1

1

Amplificateur à gain variable et dispositif
d'animation d'enseigne lumineuse en
comportant application.-

La présente invention se rapporte aux amplificateurs et concerne plus particulièrement un amplificateur
à gain variable.

Elle concerne également les dispositifs d'animation d'enseignes lumineuses auxquels l'amplificateur
précité peut être appliqué.

Les dispositifs d'animation d'enseignes lumineuses connus comprennent généralement des transformateurs
d'alimentation à partir du secteur de tronçons successifs
de tubes à décharge à gaz rare constituant l'enseigne et un
commutateur assurant les mises en tension et hors tension successives des transformateurs en vue d'obtenir
l'effet d'animation recherché.

Ces dispositifs d'animation présentent l'inconvénient de nécessiter l'emploi d'autant de transformateurs
que de tronçons de tubes à alimenter, chaque transformateur
devant être adapté à la longueur des tubes correspondant,
ce qui rend leur installation coûteuse.

En outre, ils consomment une énergie non négligeable, ce qui augmente considérablement leur coût d'exploitation.

Ils sont de plus sensibles aux écarts de température, notamment dans les régions froides.

L'invention vise à remédier aux inconvénients
précités en créant un dispositif d'animation qui tout en
étant d'une construction relativement simple, soit d'un
emploi plus souple et plus économique que les dispositifs
d'animation classiques.

2

Elle a donc pour objet un amplificateur de tension continue à gain variable, caractérisé en ce qu'il comprend un convertisseur de tension-fréquence destiné à engendrer des signaux rectangulaires de fréquence proportionnelle à la tension qui lui est appliquée, des moyens de commutation d'une tension continue élevée au rythme de la fréquence desdits signaux rectangulaires et des moyens d'intégration desdits signaux résultant de la commutation.

Suivant une autre caractéristique de l'invention, lesdits moyens de commutation de la tension continue comprennent un premier transistor connecté par sa base à la sortie du convertisseur de tension-fréquence et dont le trajet collecteur-émetteur est branché en série avec l'enroulement primaire d'un transformateur, l'enroulement secondaire de celui-ci étant connecté entre la base de l'émetteur d'un second transistor dont le trajet émetteur-collecteur est connecté entre la source de tension continue élevée et un condensateur qui constitue lesdits moyens d'intégration.

L'invention a également pour objet un dispositif d'animation d'enseigne lumineuse constitué par un tube à décharge à gaz rare pourvu d'une électrode à chacune de ses extrémité, ce dispositif comportant un générateur de signaux de fréquence comprise entre 5 et 100 KHz pour alimenter ledit tube et étant caractérisé en ce qu'il comporte en outre un amplificateur à gain variable tel que défini ci-dessus, connecté à l'entrée dudit générateur et un circuit de commande dudit amplificateur à gain variable en fonction de la tension souhaitée à la sortie de celui-ci.

D'autres caractéristiques de l'invention apparaîtront au cours de la description qui va suivre :

Aux dessins annexés, donnés uniquement à titre d'exemple :

3

— la Fig.1 est un schéma d'un dispositif d'animation d'enseigne lumineuse suivant l'invention;

— la Fig.2 est un schéma plus détaillé de l'amplificateur à gain variable qui fait partie du dispositif de la Fig.1.

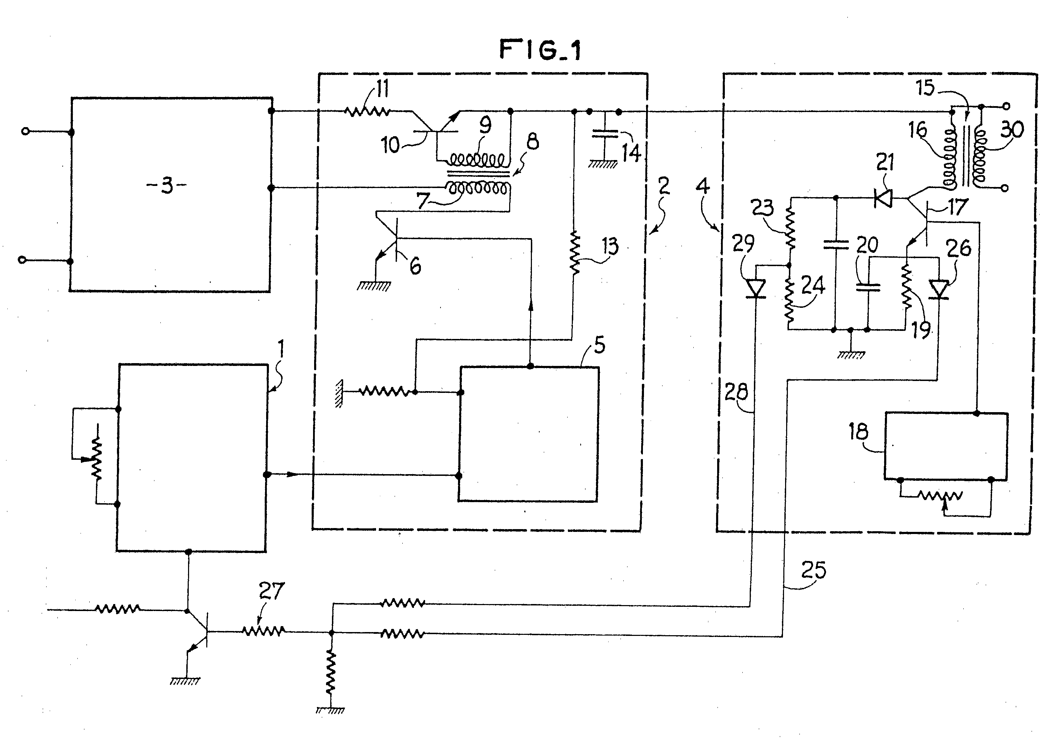

Le dispositif d'animation d'enseigne lumineuse représenté à la Fig.1 comporte un générateur 1 de signaux en forme de rampe constituant la base de temps du dispositif et dont la sortie est connectée à l'entrée d'un amplificateur 2 à gain variable connecté par ailleurs à une source de tension continue 3. La sortie de l'amplificateur 2 est connectée à un générateur de signaux 4 de fréquence égale à 20 KHz environ, dont la sortie est destinée à être connectée à une charge non représentée, constituée par un tube d'enseigne lumineuse dont il y a lieu d'assurer l'animation.

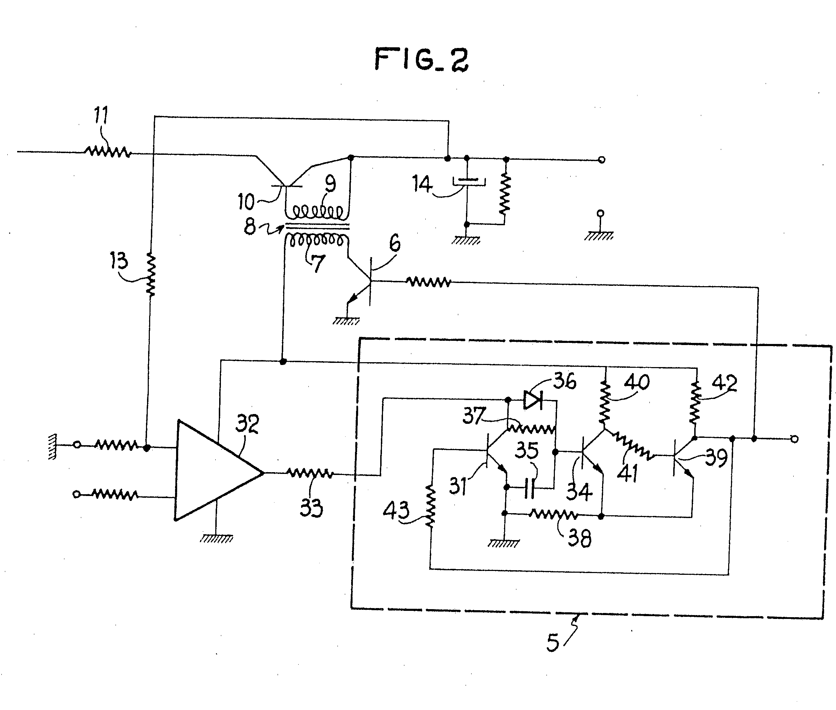

L'amplificateur à gain variable 2 dont une description détaillée sera donnée en référence à la Fig.2, comporte un convertisseur de tension-fréquence 5 dont l'entrée est connectée au circuit de base de temps 1 et dont la sortie est connectée à la base d'un transistor NPN 6.

Le collecteur de ce transistor est connecté à l'enroulement primaire 7 d'un transformateur 8 connecté à une borne de sortie de la source 3 de tension continue. La tension délivrée par la source 3 à l'enroulement 7 est dans le présent exemple égale à + 12V.

L'enroulement secondaire 9 du transformateur 8 est connecté entre la base et l'émetteur d'un transistor NPN 10, dont le collecteur est connecté à une borne de tension plus élevée de la source 3 par l'intermédiaire d'une résistance 11 destinée à supporter de fortes intensités. La tension appliquée à la résistance 11 est de 250V.

4

L'émetteur du transistor 10 est connecté à une entrée de référence du convertisseur 5 par l'intermédiaire d'une résistance 13 connectée à une borne d'un condensateur 14, dont l'autre borne est connectée à la masse.

Le point de jonction de la résistance 13 et du condensateur 14, constitue la sortie de l'amplificateur à gain variable 2 et l'entrée du générateur 4.

Ce générateur comprend un transformateur 15 dont le primaire 16 est connecté en série dans le trajet collecteur-émetteur d'un transistor NPN 17. La base de ce transistor est connectée à la sortie d'un oscillateur de commande 18, générateur de signaux rectangulaires.

L'émetteur du transistor 17 est en outre connecté à la masse par l'intermédiaire d'une résistance 19 et d'un condensateur 20 branchés en parallèle, tandis que son collecteur est connecté à l'anode d'une diode 21 dont la cathode est également reliée à la masse par un condensateur 22 connecté en parallèle avec deux résistances en série 23, 24.

L'émetteur du transistor 17 est connecté à un circuit de sécurité de court-circuit ou de surcharge 25 comportant une diode 26 et un inverseur 27 destiné à assurer la suppression de la tension de sortie du générateur de rampe 1.

Le point de jonction des résistances 23 et 24 est connecté à un circuit 28 de sécurité en cas de surtension, comprenant une diode 29 et le même inverseur 27.

Le secondaire 30 du transformateur 15 est destiné à être connecté à une charge non représentée, constituée par un ou plusieurs tubes à gaz rare tel que néon ou argon branchés en série ou en parallèle.

L'amplificateur à gain variable 2 est représenté plus en détail à la Fig.2.

Le convertisseur de tension-fréquence 5 est constitué dans le présent exemple par un oscillateur délivrant des impulsions à des fréquences variables, compor-

5

tant un premier transistor NPN 31 dont l'émetteur est connecté à la masse et dont le collecteur est relié à la sortie d'un amplificateur opérationnel 32 par l'intermédiaire d'une résistance 33. L'émetteur du transistor 31 est en outre relié à la base d'un transistor NPN 34 par l'intermédiaire d'un condensateur 35 et son collecteur est connecté à la base de ce même transistor par l'intermédiaire d'une diode 36 et d'une résistance 37 branchées en parallèle. L'émetteur du transistor 34 est relié à la masse par l'intermédiaire d'une résistance 38 et à l'émetteur d'un troisième transistor 39.

Le collecteur du transistor 34 est connecté à une borne d'alimentation de l'amplificateur 32 par une résistance 40. Il est en outre connecté à la base du transistor 31 par une résistance 41. Le collecteur du transistor 39 est relié à la borne d'alimentation de l'amplificateur 32 par une résistance 42 et à la base du transistor 31 par une résistance 43. Il constitue enfin la sortie du convertisseur et est connecté à la base du transistor 6 représenté à la Fig.1.

Le fonctionnement de l'oscillateur 5 a été décrit dans la demande de brevet N° 78 28 190 déposée le 3 Octobre 1978 par le Demandeur et intitulée "Oscillateur d'impulsions à fréquences variables".

Le fonctionnement de l'amplificateur à gain variable qui vient d'être décrit est le suivant.

La tension appliquée à l'amplificateur 32 est amplifiée par celui-ci et transmise à l'oscillateur 5 qui la convertit en un signal constitué d'impulsions rectangulaires de durée constante dont le nombre par unité de temps est proportionnel à la tension de sortie de l'amplificateur 32.

Les impulsions émises par l'oscillateur 5 provoquent la conduction à leur cadence du transistor 6 et l'apparition sur le primaire 7 du transformateur 8 d'une tension impulsionnelle correspondante. Le signal qui en résul-

6.

te sur le secondaire 9 du transformateur 7 provoque la saturation et le blocage successifs du transistor 10 et, pendant les périodes de saturation, la charge du condensateur 14 à une valeur proportionnelle au nombre d'impulsions par seconde délivrées par l'oscillateur 5.

La résistance 13 rend la tension apparaissant aux bornes du condensateur 14, linéairement proportionnelle à la tension reçue par l'amplificateur opérationnel.

La tension aux bornes du condensateur 14 est une tension continue à laquelle se superpose une faible composante en dent de scie.

Le fonctionnement de l'amplificateur à gain variable ayant été décrit, on va décrire maintenant celui du dispositif d'animation de la Fig.1.

On suppose que la charge connectée aux bornes du secondaire 30 du transformateur 15 est un tube à décharge à gaz rare de grande longueur comportant une électrode à chacune de ses extrémités, ce tube devant être allumé progressivement, puis éteint.

On sait que par effet herzien, un tube à décharge de ce genre peut être allumé sur une partie ou sur la totalité de sa longueur, la longueur de la portion allumée étant fonction de la tension d'alimentation appliquée au tube.

C'est cet effet qu'utilise le dispositif d'animation suivant l'invention.

Le générateur 1 fournit des signaux en forme de rampe dont la période correspond à la période d'allumage et d'extinction du tube connecté au secondaire 30 du transformateur 15.

Chaque rampe du signal du générateur 1 est convertie par le convertisseur 5 en un train d'impulsions qui sert à commander le transistor 6, le transformateur 7 et le transistor 10 qui assure la commutation de la tension continue appliquée à son collecteur par la source 3. Cette tension commutée est ensuite intégrée par le condensateur 14.

7

On dispose donc à la sortie de l'amplificateur 2 d'une tension continue qui est appliquée au primaire 16 du transformateur 15.

L'oscillateur 18 délivre un signal d'une fréquence de l'ordre de 15 à 25 KHz.

Ce signal attaque la base du transistor 17 et commande à chaque impulsion, la conduction de celui-ci, de sorte que la tension sur le primaire 16 module en amplitude le signal de l'oscillateur 18 et que sur le secondaire 30 apparaît une tension à la fréquence dudit oscillateur 18 et proportionnelle à la tension délivrée par l'amplificateur à gain variable.

La plage de variation de la tension aux bornes du secondaire 30 du transformateur 15 étant calculée pour que sa valeur maximale corresponde à l'allumage du tube à décharge sur toute sa longueur, on comprend aisément que la variation de la longueur de tube allumée est directement proportionnelle à la valeur de la tension de sortie du transformateur 15.

Si un court-circuit se produit aux bornes du secondaire 30 du transformateur 15, il y a une brusque augmentation du courant dans le primaire 16 et dans le transistor 17, ce qui provoque une augmentation de sa tension émetteur. Cette tension est transmise par la diode 26 à l'inverseur 27 dont le transistor est rendu conducteur et provoque la coupure de la tension de sortie du générateur 1 et par conséquent l'interruption immédiate de l'alimentation du tube à décharge.

Lorsqu'au lieu d'un court-circuit, il se produit une surcharge, le fonctionnement du circuit de sécurité 25 est le même.

Si la charge connectée aux bornes du secondaire 30 du transformateur 15 est le siège d'une surtension, la tension sur le primaire augmente, cette tension étant transmise par la diode 21 et le diviseur de tension 23,24, à la diode 29 qui provoque comme précédemment la

0016687

8

conduction du transistor de l'inverseur 27 et la coupure de la tension de sortie du générateur 1.

Dans le présent mode de réalisation, le générateur 1 est un générateur de signaux en forme de rampe jouant le rôle de circuit de base de temps pour commander l'allumage progressif et l'extinction périodique du tube à décharge connecté à la sortie du dispositif d'animation.

On comprendra cependant que ce générateur peut être remplacé par tout autre type de source de tension susceptible de commander l'allumage et l'extinction du tube à décharge à un rythme quelconque.

Si l'on souhaite faire varier l'éclairage d'une salle de discothèque équipée de rampes lumineuses d'ambiance, il est possible de remplacer le générateur 1 par une source de tension continue modulée par un microphone ou par un étage de sortie d'une installation de sonorisation auquel cas, l'éclairage peut fluctuer en synchronisme avec la musique.

Dans le mode de réalisation de l'amplificateur à gain variable représenté à la Fig.2, le convertisseur de tension-fréquence est du type décrit dans la demande de brevet précitée.

On comprendra toutefois que tout convertisseur de tension-fréquence de caractéristiques semblables conviendrait également.

Bien que dans les modes de réalisation représentés, le collecteur du transistor 10 de l'amplificateur à gain variable 2 soit connecté à la source d'alimentation 3 par une résistance 11, cette résistance peut être remplacée par une impédance d'une autre nature telle qu'une bobine de self inductance.

Le dispositif suivant l'invention présente vis-à-vis des dispositifs classiques, les avantages suivants.

- Il est d'un emploi économique car il consomme dans les cas les plus défavorables, quatre fois moins d'énergie que les dispositifs classiques et ceci en raison d'une part de l'absence presque totale de courants de Foucault aux fréquences de leur générateur d'alimentation et d'autre part au fonctionnement des tubes par effet herzien.

- Il peut fonctionner à des températures très basses pouvant atteindre -40°C.

- Il peut également assurer l'alimentation de tubes de qualité médiocre.

- Il est d'une souplesse d'emploi très supérieure aux dispositifs classiques, et par construction il est peu coûteux et d'un très faible poids.

Dans le mode de réalisation décrit et représenté, les signaux de sortie au niveau du transformateur 15 présentent des harmoniques nuisibles à l'écoute de certaines émissions de radiodiffusion.

Afin de supprimer ces harmoniques il suffit d'associer au transformateur 15 un filtre approprié.

Par ailleurs, afin d'isoler la sortie du circuit vis à vis du secteur, on peut adjoindre au transformateur de sortie, un transformateur d'isolement.

10

REVENDICATIONS

1. Amplificateur de tension continue à gain variable, caractérisé en ce qu'il comprend un convertisseur de tension-fréquence (5) destiné à engendrer des signaux rectangulaires de fréquence proportionnelle à la tension qui lui est appliquée, des moyens (6,8,10) de commutation d'une tension continue élevée au rythme de la fréquence desdits signaux rectangulaires et des moyens (14) d'intégration desdits signaux résultant de la commutation.

2. Amplificateur suivant la revendication 1, caractérisé en ce que lesdits moyens de commutation de la tension continue comprennent une premier transistor (6) connecté par sa base à la sortie du convertisseur de tension-fréquence (5) et dont le trajet collecteur-émetteur est branché en série avec l'enroulement primaire (7) d'un transformateur (8), l'enroulement secondaire (9) de celui-ci étant connecté entre la base et l'émetteur d'un second transistor (10) dont le trajet émetteur-collecteur est connecté entre la source de tension continue élevée et un condensateur (14) qui constitue lesdits moyens d'intégration.

3. Amplificateur suivant la revendication 2, caractérisé en ce qu'en série avec le trajet émetteur-collecteur du transistor (10) est connectée une impédance (11) constituée par une résistance supportant de fortes intensités ou par une bobine de self inductance.

4. Amplificateur suivant l'une quelconque des revendications 1 à 3, caractérisé en ce qu'il comporte en outre un amplificateur opérationnel (32) connecté à l'entrée dudit convertisseur de tension-fréquence, le condensateur d'intégration (14) étant connecté à l'entrée de référence dudit amplificateur (32) par l'intermédiaire d'une résistance (13).

5. Dispositif d'animation d'enseigne lumineuse constituée par au moins un tube à décharge à gaz rare pourvu d'une électrode à chacune de ses extrémités, ce dispositif comportant un générateur de signaux de fréquence comprise entre 5 et 100 KHz pour alimenter ledit tube, caractérisé en ce qu'il comporte en outre un amplificateur à gain variable suivant l'une quelconque des revendications 1 à 4, connecté à l'entrée dudit générateur (4) et un circuit (1) de commande dudit amplificateur à gain variable (2) en fonction de la tension souhaitée à la sortie de celui-ci.

6. Dispositif suivant la revendication 5, caractérisé en ce que ledit circuit de commande (1) est un générateur de signaux en forme de rampe constituant un circuit de base de temps pour le dispositif.

7. Dispositif suivant la revendication 5, caractérisé en ce que ledit circuit de commande (1) est une source de tension continue commandée par un dispositif de modulation, tel qu'un microphone ou un étage de sortie d'une installation de sonorisation dont on souhaite assurer l'éclairage d'ambiance au rythme de la musique.

8. Dispositif suivant la revendication 7, caractérisé en ce qu'il comprend un circuit (25,26,27) de sécurité en cas de court-circuit ou de surcharge destiné à couper le signal de sortie du circuit de commande (1) lorsqu'un court-circuit ou une surcharge se produit sur le tube à décharge du dispositif.

9. Dispositif suivant l'une quelconque des revendications 7 et 8, caractérisé en ce qu'il comprend un circuit (28,29,27) de sécurité en cas de surtension destiné à couper le signal de sortie du circuit de commande (1) en présence d'une surtension.

FIG_1

# FIG_2